# EUROPEAN PATENT APPLICATION

(11) **EP 4 644 045 A1**
(43) Date of publication of application: **05.11.2025**
(21) Application number: 23911506.6
(22) Date of filing: 28.11.2023
(51) Int. Cl.: B24B 37/30, B24B 37/12, H01L 21/304

(54) **SUBSTRATE SUCTION MEMBER, TOP RING, AND SUBSTRATE PROCESSING DEVICE**

(30) Priority: 27.12.2022 JP 2022209628; 27.12.2022 JP 2022209633
(71) Applicant: EBARA CORPORATION, Ota-ku, Tokyo 144-8510 (JP)
(72) Inventor: YOSHIDA, Atsushi, Tokyo 144-8510 (JP); ONO, Koji, Tokyo 144-8510 (JP)
(74) Representative: Schmidbauer, Andreas Konrad
(86) International application number: PCT/JP2023/042611
(87) International publication number: WO 2024/142725

(57) **Abstract**

An object of the present application is to hold a substrate stably while preventing a peripheral edge portion of the substrate from being broken.

A substrate suction member 330 includes a porous member 334 that includes a substrate suction surface 334a for suctioning a substrate WF and pressure reducers 334b communicating with pressure reducing means 31, a shielding member 332 shielding a surface 334c of the porous member 334 opposite to the substrate suction surface 334a, and a bag member 336 disposed so as to surround the porous member 334 and communicating with a gas supply source 331.

## Description

### TECHNICAL FIELD

The present application relates to a substrate suction member, a top ring, and a substrate processing apparatus.

### BACKGROUND ART

A chemical mechanical polishing (CMP) apparatus is used to planarize a surface of a substrate in manufacture of semiconductor devices. The substrate used in the manufacture of semiconductor devices often has a circular-plate shape. Not only for the semiconductor devices, but also for quadrangular substrates, such as copper clad laminate substrates (CCL substrates), printed circuit board (PCB) substrates, photomask substrates, and display panels, there is an increasing demand for flatness when the substrate surfaces are planarized. Further, there is an increasing demand for planarizing surfaces of package substrates on which electronic devices such as PCB substrates are arranged.

A substrate processing apparatus, such as a chemical mechanical polishing apparatus, includes a top ring for holding a substrate. For example, as described in PTL 1, the top ring includes a rotation shaft, a flange coupled to the rotation shaft, a porous suction plate fitted to an opening provided at a center in a lower surface of the flange, and a shielding plate attached on an upper surface of the suction plate. This top ring is configured to suction the substrate via micropores of the suction plate by vacuum suction and press the substrate against a polishing pad by applying a pressure to the shielding plate.

The substrate processing apparatus, such as a chemical mechanical polishing apparatus, includes a top ring for holding and pressing a substrate against a polishing pad. For example, as described in PTL 2, it is disclosed that the top ring controls pressing forces of a substrate on a per area basis by means of a plurality of concentric pressurization chambers formed by a plurality of elastic films.

### CITATION LIST

### PATENT LITERATURE

PTL 1: Japanese Patent No. 3668529
PTL 2: Japanese Patent Application Laid-Open Publication No. 2021-79488

### SUMMARY OF INVENTION

### TECHNICAL PROBLEM

For the top ring in the related art as described in PTL 1, there is no consideration given to holding a substrate stably while preventing a peripheral edge portion of the substrate from being broken.

That is, in the related art, the suction plate is provided with a shielding plate on its upper surface and provided with a substrate holder on its side surface so as to prevent the vacuum in a porous suction plate from being lost. In addition to this, a size of the suction plate is slightly smaller than a size of a substrate so that the entire lower surface of the suction plate is closed by the substrate. Thus, the peripheral edge portion of the substrate is to come into contact with the substrate holder. Therefore, for example, when a brittle substrate such as a thin glass substrate is suctioned, a peripheral edge portion of the substrate comes into contact with the substrate holder and may be broken by a reaction force from the substrate holder.

If a position of a lower surface of the substrate holder is raised to prevent such breakage of the peripheral edge portion of the substrate, the vacuum may be lost from the side surface of the suction plate, failing to suction the substrate stably.

Hence, an object of the present application is to hold a substrate stably while preventing a peripheral edge portion of a substrate from being broken.

For the top ring in the related art as described in PTL 2, there is no consideration given to flexible adjustment of the pressurization areas of a substrate.

That is, the top ring in the related art has fixed pressurization areas, thus making it difficult to adjust a polishing profile of a substrate. As a result, for example, in order to change the pressurization areas in accordance with a type of a substrate, it is necessary to fabricate elastic films and incorporate the elastic films into the top ring for each type of the substrate. This is a complicated operation.

Hence, an object of the present application is to flexibly adjust pressurization areas of a substrate.

### SOLUTION TO PROBLEM

According to one embodiment, disclosed is a substrate suction member including a porous member that includes a substrate suction surface for suctioning a substrate and pressure reducers communicating with pressure reducing means, a shielding member shielding a surface of the porous member opposite to the substrate suction surface, and a bag member disposed so as to surround the porous member and communicating with a gas supply source.

According to one embodiment, a top ring for holding and pressing a substrate against a polishing surface is disclosed. The top ring includes a plurality of bag members configured to press the substrate using a gas supplied from a gas supply source and a distribution mechanism including a channel for distributing the gas supplied from the gas supply source to the plurality of bag members. The distribution mechanism is configured such that the channel is switchable between a first channel for distributing the gas to a plurality of first groups into which the plurality of bag members are configured to be grouped and a second channel for distributing the gas to a plurality of second groups that are different from the plurality of first groups and into which the plurality of bag members are configured to be grouped.

### BRIEF DESCRIPTION OF DRAWINGS

Fig. 1 is a plan view illustrating an overall configuration of a substrate processing apparatus according to one embodiment.
Fig. 2 is a perspective view schematically illustrating a configuration of a polishing unit according to the one embodiment.
Fig. 3A is a cross-sectional view schematically illustrating a top ring of the one embodiment.
Fig. 3B is a plan view schematically illustrating the top ring of the one embodiment.
Fig. 4 is a cross-sectional view schematically illustrating a partially enlarged top ring of the one embodiment.
Fig. 5A is a cross-sectional view schematically illustrating a partially enlarged top ring of one embodiment.
Fig. 5B is a plan view schematically illustrating a partially enlarged top ring in Fig. 5A.
Fig. 6A is a cross-sectional view schematically illustrating a part of a top ring of one embodiment.
Fig. 6B is a plan view schematically illustrating a partially enlarged top ring in Fig. 6A.
Fig. 7 is a cross-sectional view schematically illustrating a partially enlarged top ring of one embodiment.
Fig. 8A is a cross-sectional view schematically illustrating a partially enlarged top ring of one embodiment.
Fig. 8B is a plan view schematically illustrating the top ring of the one embodiment.
Fig. 9 is a cross-sectional view schematically illustrating a partially enlarged top ring of one embodiment.
Fig. 10A is a cross-sectional view schematically illustrating the top ring of one embodiment.
Fig. 10B is a plan view schematically illustrating the top ring in Fig. 10A.
Fig. 10C is a cross-sectional view schematically illustrating a partially enlarged top ring in Fig. 10A.
Fig. 10D is a cross-sectional view schematically illustrating the top ring of one embodiment.
Fig. 10E is a plan view schematically illustrating a modification of the grouping of bag members.
Fig. 10F is a plan view schematically illustrating a modification of the grouping of the bag members.
Fig. 10G is a plan view schematically illustrating a modification of the grouping of the bag members.
Fig. 10H is a plan view schematically illustrating a modification of the grouping of the bag members.
Fig. 11A is a cross-sectional view schematically illustrating a top ring of one embodiment.
Fig. 11B is a plan view schematically illustrating the top ring in Fig. 11A.
Fig. 11C is a cross-sectional view schematically illustrating the top ring of one embodiment.
Fig. 11D is a plan view schematically illustrating the top ring in Fig. 11C.
Fig. 11E is a cross-sectional view schematically illustrating a partially enlarged top ring in Fig. 11C.
Fig. 12 is a cross-sectional view schematically illustrating a top ring of one embodiment.
Fig. 13 is a cross-sectional view schematically illustrating a partially enlarged top ring of one embodiment.
Fig. 14 is a cross-sectional view schematically illustrating a partially enlarged top ring of one embodiment.
Fig. 15 is a cross-sectional view schematically illustrating a partially enlarged top ring of one embodiment.

### DESCRIPTION OF EMBODIMENTS

The following describes embodiments of a substrate suction member, a top ring, and a substrate processing apparatus according to the present invention with attached drawings. In the attached drawings, identical or similar reference numerals are attached to identical or similar components, and overlapping description regarding the identical or similar components may be omitted in the description of the respective embodiments. Features illustrated in the respective embodiments are applicable to other embodiments in so far as they are consistent with one another.

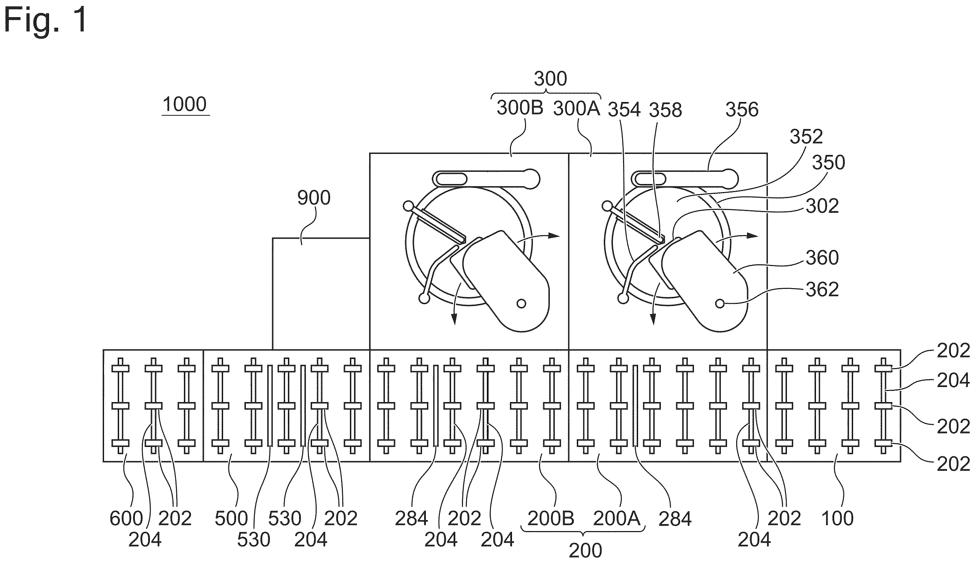

Fig. 1 is a plan view illustrating an overall configuration of a substrate processing apparatus 1000 according to one embodiment. The substrate processing apparatus 1000 illustrated in Fig. 1 includes a loading unit 100, a transfer unit 200, a polishing unit 300, a drying unit 500, and an unloading unit 600. In the illustrated embodiment, the transfer unit 200 includes two transfer units 200A and 200B, and the polishing unit 300 includes two polishing units 300A and 300B. In one embodiment, each of these units can be independently formed. Independently forming these units can easily form the substrate processing apparatus 1000 having a different configuration by conveniently combining the numbers of the respective units. The substrate processing apparatus 1000 also includes a control device 900, and the control device 900 controls each component of the substrate processing apparatus 1000. In one embodiment, the control device 900 can be configured of a general computer including, for example, an input and output device, an arithmetic device, and a storage device.

### <Loading Unit>

The loading unit 100 is a unit for introducing a substrate WF before processing, such as polishing and cleaning, is performed into the substrate processing apparatus 1000. In the one embodiment, the loading unit 100 is configured to comply with Mechanical Equipment Interface Standard (IPC-SMEMA-9851) of Surface Mount Equipment Manufacturers Association (SMEMA).

In the illustrated embodiment, a transfer mechanism of the loading unit 100 includes a plurality of transfer rollers 202 and a plurality of roller shafts 204 to which the transfer rollers 202 are mounted. In the embodiment illustrated in Fig. 1, each roller shaft 204 is mounted with three transfer rollers 202. The substrate WF is arranged on the transfer rollers 202, and the substrate WF is transferred as the transfer rollers 202 rotate. The installation positions of the transfer rollers 202 on the roller shafts 204 can be anywhere as long as the substrate WF can be stably transferred. However, since the transfer rollers 202 come into contact with the substrate WF, the transfer rollers 202 should be arranged such that the transfer rollers 202 come into contact with regions having no problem even when contacting the substrate WF as a process target. In one embodiment, the transfer rollers 202 of the loading unit 100 can be formed of a conductive polymer. In the one embodiment, the transfer rollers 202 are electrically grounded via the roller shafts 204 or the like. This avoids damage to the substrate WF due to being charged. Additionally, in one embodiment, the loading unit 100 may be provided with an ionizer (not illustrated) for preventing the substrate WF from getting electrically charged.

### <Transfer Unit>

The substrate processing apparatus 1000 illustrated in Fig. 1 includes the two transfer units 200A and 200B. Since the two transfer units 200A and 200B can have the same configuration, they will be described collectively as the transfer unit 200 below.

The illustrated transfer unit 200 includes the plurality of transfer rollers 202 for transferring the substrate WF. By rotating the transfer rollers 202, the substrate WF on the transfer rollers 202 can be transferred in a predetermined direction. The transfer rollers 202 of the transfer unit 200 may be formed of a conductive polymer or may be formed of a nonconductive polymer. The transfer rollers 202 are driven by a motor (not illustrated). The substrate WF is transferred to a substrate gripping or releasing position by the transfer rollers 202.

In the one embodiment, the transfer unit 200 includes a cleaning nozzle 284. The cleaning nozzle 284 is connected to a supply source of a cleaning liquid (not illustrated). The cleaning nozzle 284 is configured to supply the cleaning liquid to the substrate WF transferred by the transfer rollers 202.

### <Polishing Unit>

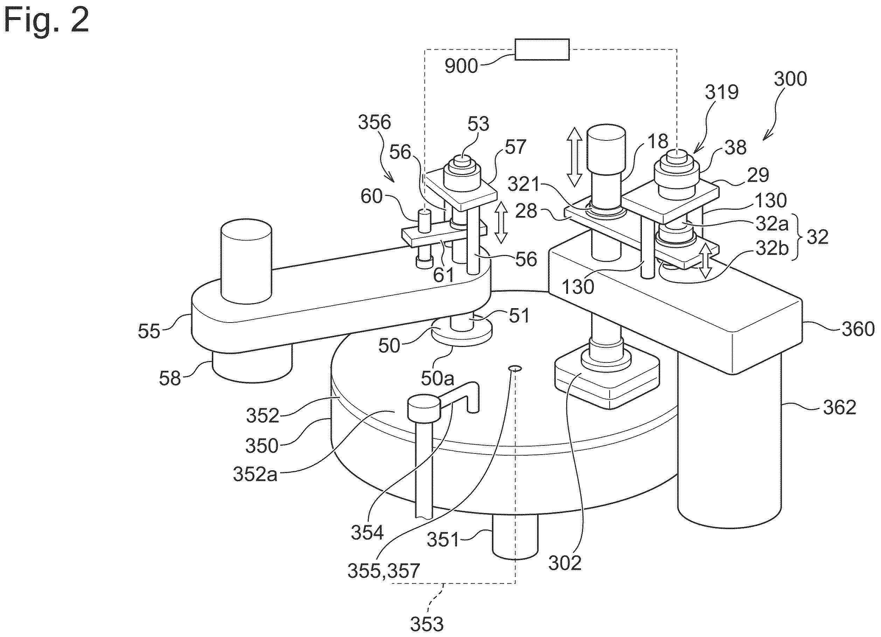

Fig. 2 is a perspective view schematically illustrating a configuration of the polishing unit 300 according to one embodiment. The substrate processing apparatus 1000 illustrated in Fig. 1 includes two polishing units 300A and 300B. Since the two polishing units 300A and 300B can have the same configuration, they will be described collectively as the polishing unit 300 below.

As illustrated in Fig. 2, the polishing unit 300 includes a polishing table 350 and a top ring 302 constituting a polishing head that holds and presses the substrate to be polished against a polishing surface on the polishing table 350. The polishing table 350 is coupled to a polishing table rotation motor (not illustrated) arranged below the polishing table 350 via the table shaft 351 and is rotatable around the table shaft 351. A polishing pad 352 is attached to an upper surface of the polishing table 350, and a surface 352a of the polishing pad 352 constitutes a polishing surface that polishes the substrate. In one embodiment, the polishing pad 352 may be attached via a layer for facilitating peeling from the polishing table 350. Such a layer includes, for example, a silicone layer or a fluorine-based resin layer, and for example, those described in Japanese Unexamined Patent Application Publication No. 2014-176950 may be used.

A polishing liquid supply nozzle 354 is installed above the polishing table 350, and a polishing liquid is supplied onto the polishing pad 352 on the polishing table 350 by the polishing liquid supply nozzle 354. Further, as illustrated in Fig. 2, the polishing table 350 and the table shaft 351 are provided with a passage 353 for supplying the polishing liquid. The passage 353 communicates with an opening portion 355 on the surface of the polishing table 350. A through hole 357 is formed in the polishing pad 352 at the position corresponding to the opening portion 355 of the polishing table 350, and the polishing liquid passing through the passage 353 is supplied from the opening portion 355 of the polishing table 350 and the through hole 357 of the polishing pad 352 to the surface of the polishing pad 352. Note that the numbers of the opening portions 355 of the polishing table 350 and the through holes 357 of the polishing pad 352 may be one or plural. Further, although the positions of the opening portion 355 of the polishing table 350 and the through hole 357 of the polishing pad 352 are any place, in the one embodiment, they are arranged near the center of the polishing table 350.

In the one embodiment, the polishing unit 300 includes an atomizer 358 for injecting a liquid or a mixed fluid of a liquid and a gas toward the polishing pad 352 (see Fig. 1), although the atomizer 358 is not illustrated in Fig. 2. The liquid injected from the atomizer 358 is, for example, pure water, and the gas is, for example, nitrogen gas.

The top ring 302 is connected to a top ring shaft 18, and the top ring shaft 18 moves vertically with respect to a swing arm 360 by an up-and-down motion mechanism 319. The vertical motion of the top ring shaft 18 causes the entire top ring 302 to move vertically with respect to the swing arm 360 for positioning. The top ring shaft 18 is driven by a top ring rotation motor (not illustrated) to rotate. The rotation of the top ring shaft 18 causes the top ring 302 to rotate around the top ring shaft 18.

The top ring 302 can hold a quadrangular substrate on its lower surface. The swing arm 360 is configured to be turnable around a spindle 362. The top ring 302 can move between the substrate gripping or releasing position of the above-described transfer unit 200 and an upper side of the polishing table 350 by the turn of the swing arm 360. By moving the top ring shaft 18 down, the top ring 302 can be moved down to press the substrate against the surface (polishing surface) 352a of the polishing pad 352. At this time, the top ring 302 and the polishing table 350 are each rotated, and the polishing liquid is supplied from the polishing liquid supply nozzle 354 disposed above the polishing table 350 and/or from the opening portion 355 disposed in the polishing table 350 onto the polishing pad 352. Thus, by pressing the substrate WF against the polishing surface 352a of the polishing pad 352, the surface of the substrate can be polished. During polishing of the substrate WF, the arm 360 may be fixed or swung such that the top ring 302 passes through the center of the polishing pad 352 (so as to cover the through hole 357 of the polishing pad 352).

The up-and-down motion mechanism 319, which moves the top ring shaft 18 and the top ring 302 vertically, includes a bridge 28 that rotatably supports the top ring shaft 18 via a bearing 321, a ball screw 32 mounted to the bridge 28, a support table 29 supported by support columns 130, and an AC servo motor 38 disposed on the support table 29. The support table 29 that supports the servo motor 38 is secured to the swing arm 360 via the support columns 130.

The ball screw 32 includes a screw shaft 32a coupled to the servo motor 38 and a nut 32b into which the screw shaft 32a is screwed. The top ring shaft 18 vertically moves integrally with the bridge 28. Therefore, when the servo motor 38 is driven, the bridge 28 vertically moves via the ball screw 32, whereby the top ring shaft 18 and the top ring 302 vertically move.

The polishing unit 300 according to one embodiment includes a dressing unit 356 that dresses the polishing surface 352a of the polishing pad 352. The dressing unit 356 includes a dresser 50 that is in sliding contact with the polishing surface 352a, a dresser shaft 51 to which the dresser 50 is coupled, an air cylinder 53 disposed at an upper end of the dresser shaft 51, and a swing arm 55 that rotatably supports the dresser shaft 51. A lower portion of the dresser 50 is constituted by a dressing member 50a, and needle-shaped diamond particles are attached to a lower surface of the dressing member 50a. The air cylinder 53 is disposed on a support table 57 supported by support columns 56, and the support columns 56 are secured to the swing arm 55.

The swing arm 55 is configured to be driven by a motor (not illustrated) to turn around a spindle 58. The dresser shaft 51 is driven by a motor (not illustrated) to rotate, and the rotation of the dresser shaft 51 causes the dresser 50 to rotate around the dresser shaft 51. The air cylinder 53 vertically moves the dresser 50 via the dresser shaft 51 and presses the dresser 50 against the polishing surface 352a of the polishing pad 352 with a predetermined pressing force.

The dressing of the polishing surface 352a of the polishing pad 352 is performed as follows. The dresser 50 is pressed against the polishing surface 352a by the air cylinder 53, and the pure water is simultaneously supplied to the polishing surface 352a from a pure water supply nozzle (not illustrated). In this state, the dresser 50 is rotated around the dresser shaft 51 while the swing arm 55 is swung above the polishing surface 352a, and the lower surface (the diamond particles) of the dressing member 50a is brought into sliding contact with the polishing surface 352a. Thus, the dresser 50 scrapes off the polishing pad 352 to dress the polishing surface 352a.

### <Drying Unit>

The drying unit 500 is a device for drying the substrate WF. In the substrate processing apparatus 1000 illustrated in Fig. 1, the drying unit 500 dries the substrate WF cleaned by a cleaner including the cleaning nozzle 284 of the transfer unit 200 after being polished in the polishing unit 300. As illustrated in Fig. 1, the drying unit 500 is arranged at a downstream of the transfer unit 200. The drying unit 500 includes nozzles 530 for injecting a gas toward the substrate WF being transferred on the transfer rollers 202. The gas can, for example, be compressed air or nitrogen. Blowing water droplets on the transferred substrate WF off by the drying unit 500 ensures drying the substrate WF.

### <Unloading Unit>

The unloading unit 600 is a unit for unloading the substrate WF after having undergone the processes, such as polishing and cleaning, out of the substrate processing apparatus 1000. In the substrate processing apparatus 1000 illustrated in Fig. 1, the unloading unit 600 receives the substrate after being dried in the drying unit 500. As illustrated in Fig. 1, the unloading unit 600 is arranged at a downstream of the drying unit 500. In the one embodiment, the unloading unit 600 is configured so as to comply with Mechanical Equipment Interface Standard (IPC-SMEMA-9851) of Surface Mount Equipment Manufacturers Association (SMEMA).

### <Top Ring>

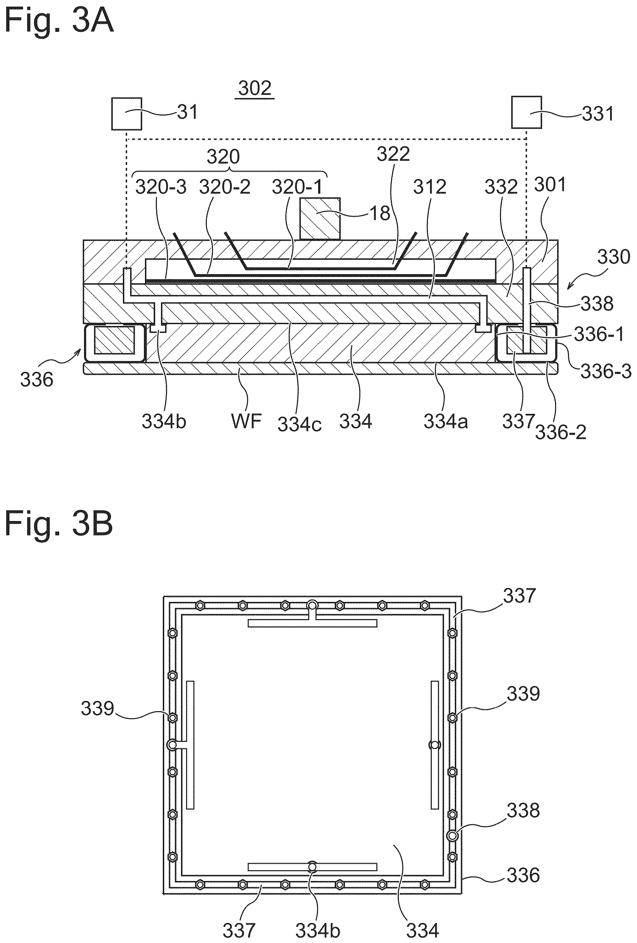

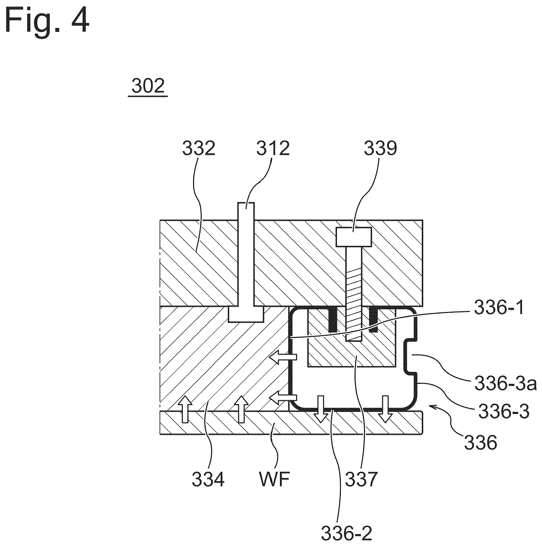

Next, the top ring 302 in the polishing unit 300 according to the one embodiment will be described. Fig. 3A is a cross-sectional view schematically illustrating a top ring of the one embodiment. Fig. 3B is a plan view schematically illustrating the top ring of the one embodiment. Fig. 4 is a cross-sectional view schematically illustrating a partially enlarged top ring of one embodiment.

As illustrated in Fig. 3A and Fig. 3B, the top ring 302 includes the top ring shaft (rotation shaft) 18 and a carrier 301 coupled to the top ring shaft 18. The top ring 302 includes a substrate suction member 330 for suctioning a back surface of the substrate WF having a surface to be polished facing downward.

The substrate suction member 330 is attached to a lower surface of the carrier 301. The substrate suction member 330 includes a porous member 334 being rectangular. It is only necessary that the porous member 334 is a member that can perform vacuum suction of the substrate WF by vacuum drawing using pressure reducing means (vacuum source) 31, and the porous member 334 can be configured of, for example, a porous resin material in which a resin is provided with multiple pores, such as polyethylene (PE), polypropylene (PP), polytetrafluoroethylene (PTFE), or polyvinyl chloride (PVC). The porous member 334 is formed in a plate shape in this embodiment and includes a substrate suction surface 334a for suctioning the substrate WF and pressure reducers 334b communicating with the pressure reducing means (vacuum source) 31. The pressure reducers 334b communicate with the pressure reducing means 31 via a gas channel 312. As illustrated in Fig. 3B, the pressure reducers 334b are provided on the four sides of the porous member 334. The pressure reducers 334b also communicate with a gas supply source 331 via the gas channel 312 so as to supply a gas (for example, N2) to the porous member 334 when the substrate WF is separated from the substrate suction member 330.

The substrate suction member 330 also includes a shielding member 332 shielding a surface 334c of the porous member 334 opposite to the substrate suction surface 334a. It is only necessary that the shielding member 332 is an airtight member that can shield the flow of gas, and can be formed of, for example, a relatively soft resin plate, such as polyethylene (PE), polypropylene (PP), polytetrafluoroethylene (PTFE), or polyvinyl chloride (PVC).

Between the carrier 301 and the shielding member 332, a pressurization space 322 for pressurizing the substrate WF is formed. The pressurization space 322 is provided with elastic films 320 forming pressurization chambers for pressurizing a plurality of regions of the substrate WF. Specifically, the elastic films 320 include a plurality of elastic films 320-1, 320-2, and 320-3 having different areas and being stacked. Edge portions of the elastic films 320-1, 320-2, and 320-3 are secured at different locations, and thus a plurality of concentric pressurization chambers for pressurizing the substrate WF are formed between the carrier 301 and the elastic films 320-1, 320-2, and 320-3. Pressures in the plurality of pressurization chambers can be adjusted by the adjustment of the respective pressures of fluid to be supplied to the pressurization chambers. The formation of the plurality of pressurization chambers enables pressing forces of the substrate WF against the polishing pad 352 to be controlled on a per area basis.

The substrate suction member 330 also includes a bag member (air bag) 336 disposed so as to surround the porous member 334. The bag member 336 is formed of an elastic film. As illustrated in Fig. 4, the bag member 336 is secured around the porous member 334 by tucking both edge portions of the elastic film into a securing member 337 and connecting the securing member 337 to a lower surface of the shielding member 332 with a plurality of bolts 339. As illustrated in Fig. 3B, the securing member 337 is secured to the shielding member 332 with the plurality of bolts 339 disposed so as to surround the porous member 334. The bag member 336 includes an inner-circumference side wall 336-1 in contact with a side surface of the porous member 334, a bottom wall 336-2 to be in contact with the substrate WF, and an outer-circumference side wall 336-3 opposed to the inner-circumference side wall 336-1. As illustrated in Fig. 3A, the bag member 336 communicates with the gas supply source 331 via a gas channel 338 communicating with the internal space of the bag member 336. The supply of a gas (for example, N2) from the gas supply source 331 to the internal space of the bag member 336 can press the substrate WF with the bottom wall 336-2. In the case where the bag member 336 is used to suction the substrate WF as will be described in the following embodiments, the bag member 336 may communicate with the pressure reducing means 31.

According to this embodiment, the bag member 336 having elasticity is disposed around the substrate suction member 330. Therefore, in the case where the substrate WF is fragile and brittle (for example, a thin glass substrate), when a peripheral edge portion of the substrate WF being suctioned comes into contact with the bag member 336, the peripheral edge portion of the substrate WF can be prevented from being broken.

In addition, the bag member 336 includes the inner-circumference side wall 336-1 in contact with the side surface of the porous member 334. With this configuration, the side surface of the porous member 334 is closed by the inner-circumference side wall 336-1 of the bag member 336. Furthermore, an upper surface of the porous member 334 is closed by the shielding member 332, and a lower surface of the porous member 334 is closed by the substrate WF. As a result, according to this embodiment, the vacuum in the porous member 334 can be prevented from being lost. It is thus possible to hold the substrate WF stably. Note that at least one of the inner-circumference side wall 336-1 or the outer-circumference side wall 336-3 may be provided with a depression for preventing the bag member 336 from deforming (for example, a depression 336-3a illustrated in Fig. 4)

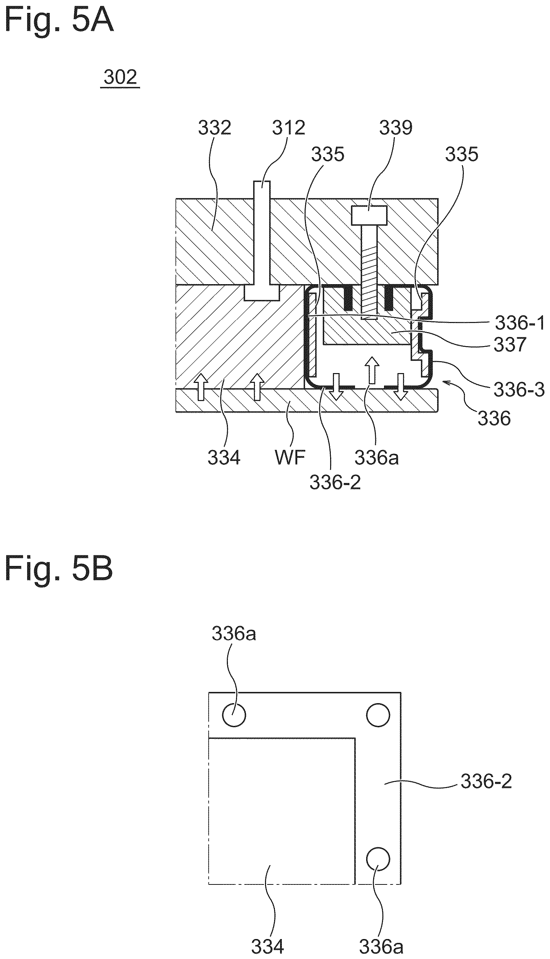

Another embodiment of the top ring will be described below. In the following, the description of the same components as in the above embodiments will be omitted. Fig. 5A is a cross-sectional view schematically illustrating a partially enlarged top ring of one embodiment. Fig. 5B is a plan view schematically illustrating a partially enlarged top ring in Fig. 5A.

As illustrated in Fig. 5A, in an internal space of the bag member 336, reinforcing members 335 having a higher stiffness than the bag member 336 may be attached to the inner-circumference side wall 336-1 and the outer-circumference side wall 336-3. The reinforcing members 335 may each be a plate-shaped member formed of a metal such as a stainless steel. The provision of the reinforcing members 335 can prevent the bag member 336 from deforming. In this embodiment, the example in which the reinforcing members 335 are attached to the inner-circumference side wall 336-1 and the outer-circumference side wall 336-3 is described. However, not limited to this, a reinforcing member 335 may be attached to at least one of the inner-circumference side wall 336-1 or the outer-circumference side wall 336-3.

As illustrated in Fig. 5A and Fig. 5B, the bottom wall 336-2 may have a plurality of holes 336a disposed so as to surround the porous member 334. In the case where the bottom wall 336-2 is provided with the plurality of holes 336a, the bag member 336 may communicate with the pressure reducing means 31 via the gas channel 338 illustrated in Fig. 3A. In this case, the top ring 302 can suction a center portion of the substrate WF with the porous member 334 and can also suction the peripheral edge portion of the substrate WF via the plurality of holes 336a. It is thus possible to hold the substrate WF more stably. Note that also in the case where the bottom wall 336-2 is provided with the plurality of holes 336a, the peripheral edge portion of the substrate WF can be pressurized by supplying the gas to the bag member 336 when the substrate WF is polished.

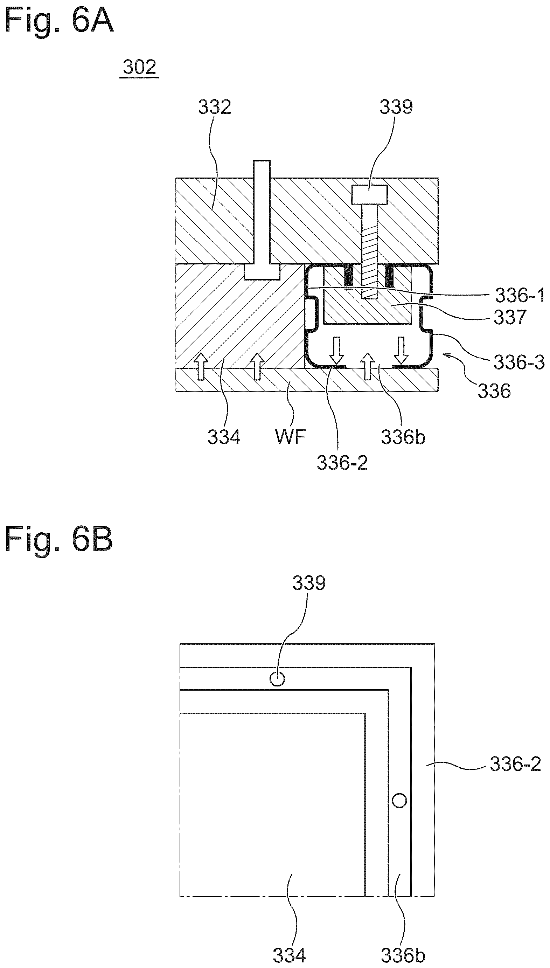

Fig. 6A is a cross-sectional view schematically illustrating a part of a top ring of one embodiment. Fig. 6B is a plan view schematically illustrating a partially enlarged top ring in Fig. 6A. As illustrated in Fig. 6A and Fig. 6B, the bottom wall 336-2 may have a slit 336b formed so as to surround the porous member 334. By forming the slit 336b in the bottom wall 336-2, it is possible to suction the peripheral edge portion of the substrate WF more strongly via the slit 336b. In addition, the formation of the slit 336b makes a contact area between the bottom wall 336-2 and the substrate WF small. Thus, it is possible to facilitate the separation of the substrate WF from the substrate suction member 330.

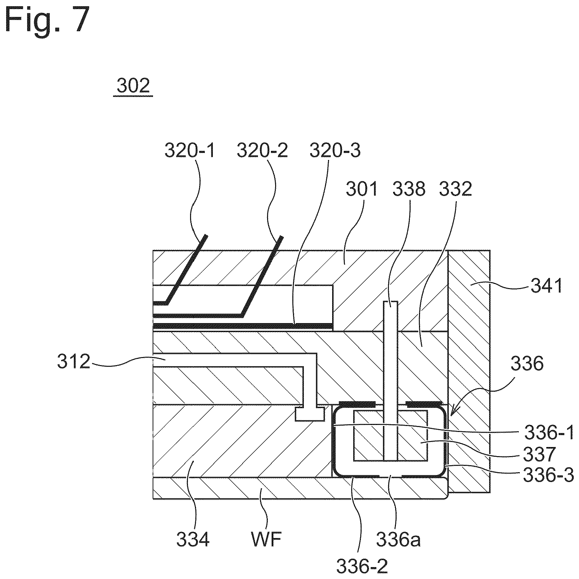

Fig. 7 is a cross-sectional view schematically illustrating a partially enlarged top ring of one embodiment. The top ring 302 may include a restricting member 341 disposed so as to surround the outer-circumference side wall 336-3 of the bag member 336. The restricting member 341 is a plate-shaped member surrounding the outer-circumference side wall 336-3. The restricting member 341 is configured to restrict the outward expansion of the bag member 336. The provision of the restricting member 341 causes the bag member 336 to expand downward when the gas is supplied to the bag member 336. It is thus possible to press the substrate WF efficiently and to separate the substrate WF from the bag member 336 efficiently. In this embodiment, the example in which the restricting member 341 is applied to the embodiment illustrated in Fig. 5 is described. However, not limited to this, the restricting member 341 may be applied to the embodiments illustrated in Fig. 3, Fig. 4, and Fig. 6.

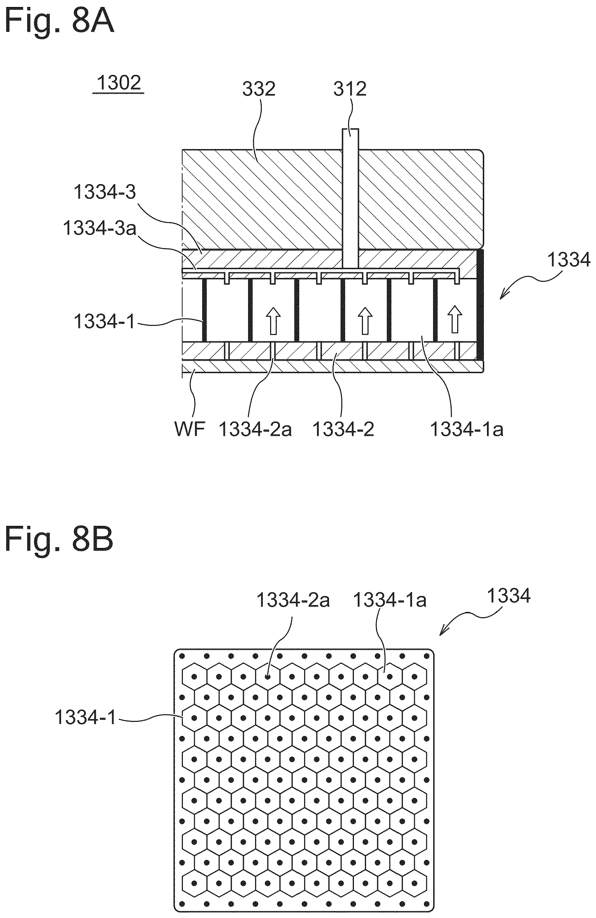

In the embodiments described above, the example in which the porous member 334 is used to suction substrate WF is described. However, how to suction the substrate WF is not limited to this. Fig. 8A is a cross-sectional view schematically illustrating a partially enlarged top ring of one embodiment. Fig. 8B is a plan view schematically illustrating the top ring of the one embodiment. The same components as those in the above embodiments will be denoted by the same reference characters.

As illustrated in Fig. 8A and Fig. 8B, a top ring 1302 includes a honeycomb-structure suction member 1334 attached to the lower surface of the shielding member 332. The honeycomb-structure suction member 1334 includes a honeycomb-structure member 1334-1, a load distribution plate 1334-2 attached to a lower surface of the honeycomb-structure member 1334-1, and a back plate 1334-3 attached to an upper surface of the honeycomb-structure member 1334-1. The honeycomb-structure member 1334-1 is a plate-shaped member having a honeycomb structure. The load distribution plate 1334-2 is a plate-shaped member formed of a metal or a resin. The load distribution plate 1334-2 is provided with through holes 1334-2a at positions corresponding to hollows 1334-1a of the honeycomb-structure member 1334-1. The back plate 1334-3 is a plate-shaped member provided with a channel 1334-3a communicating with the gas channel 312. The channel 1334-3a communicates with the hollows 1334-1a of the honeycomb-structure member 1334-1.

According to this embodiment, the entire surface of the substrate WF can be suctioned with the honeycomb-structure suction member 1334 by the suction of the gas through the gas channel 312. It is thus possible to hold the substrate WF stably. In addition, according to this embodiment, the honeycomb structure is applied to the member for suctioning the substrate. It is thus possible to achieve an increase in a strength of the top ring 1302 and a decrease in a weight of the top ring 1302. In this embodiment, the example in which the plate-shaped member formed of a metal or a resin is employed as the load distribution plate 1334-2 is described. However, the load distribution plate 1334-2 is not limited to this, and a plate member of a porous material such as the porous member 334 in the above embodiments can be employed.

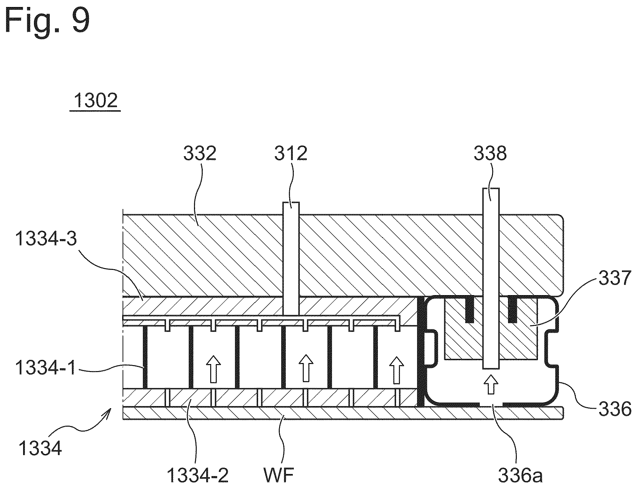

Fig. 9 is a cross-sectional view schematically illustrating a partially enlarged top ring of one embodiment. As illustrated in Fig. 9, the bag member 336 in the above embodiments and the honeycomb-structure suction member 1334 may be used in combination. That is, the top ring 1302 may include the honeycomb-structure suction member 1334 and the bag member 336 that is disposed so as to surround the honeycomb-structure suction member 1334. According to this embodiment, it is possible to achieve an increase in the strength of the top ring 1302 and a decrease in the weight of the top ring 1302 and to prevent the peripheral edge portion of the substrate WF from being broken when the substrate WF is suctioned.

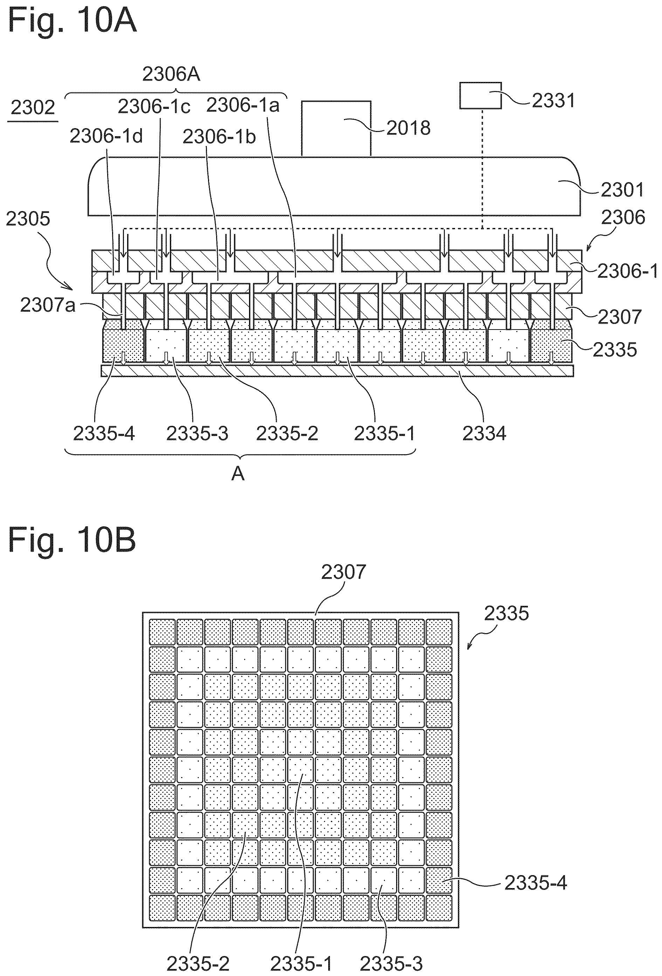

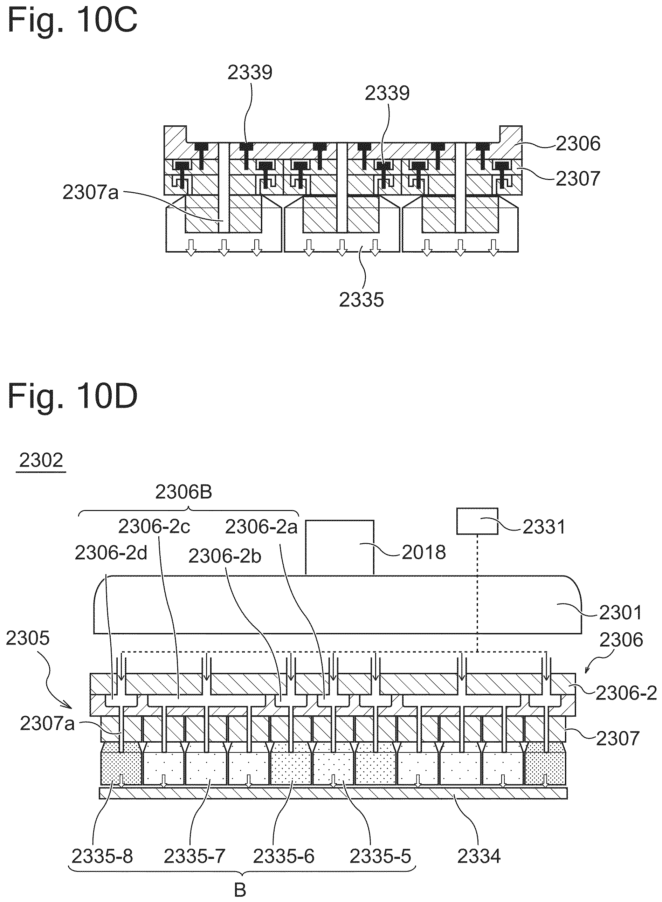

Fig. 10A is a cross-sectional view schematically illustrating the top ring of one embodiment. Fig. 10B is a plan view schematically illustrating the top ring in Fig. 10A. Fig. 10C is a cross-sectional view schematically illustrating a partially enlarged top ring in Fig. 10A. Fig. 10D is a cross-sectional view schematically illustrating the top ring of the one embodiment.

A top ring 2302 in this embodiment includes a rotation shaft 2018 and a carrier 2301 that is coupled to the rotation shaft 2018. The top ring 2302 also includes a plurality of bag members (air bags) 2335 having the same shape and the same size and being configured to press the substrate WF using a gas supplied from a gas supply source 2331 and a distribution mechanism 2305 including a channel for distributing the gas supplied from the gas supply source 2331 to the plurality of bag members 2335. The top ring 2302 also includes a suction plate 2334 provided below the plurality of bag members 2335. The distribution mechanism 2305 includes a bag member holder 2307 configured to hold the plurality of bag members 2335 and provided with communication passages 2307a communicating with internal spaces of the plurality of bag members 2335 and includes a distribution member 2306 for distributing the gas supplied from the gas supply source 2331 to the communication passages 2307a of the bag member holder 2307.

The plurality of bag members 2335 are each formed of an elastic film and are two-dimensionally arranged opposed to the pressed surface of the substrate WF. Fig. 10A illustrates the bag members 2335 in a simplified manner for convenience of description. As illustrated in Fig. 10C, the bag members 2335 are connected to the bag member holder 2307 by tucking the edge portions of the elastic films into the bag member holder 2307 and securing the bag member holder 2307 with bolts 2339. The bag member holder 2307 and the distribution member 2306 are also connected by bolts 2339. Note that the bag members 2335 may be provided with depressions on their side walls to prevent the bag members 2335 from deforming.

As illustrated in Fig. 10B, the top ring 2302 includes 11 × 11 = 121 bag members 2335. These bag members 2335 are divided into a plurality of groups. The plurality of groups are not fixed groups and are changeable in accordance with a type, a polishing recipe, or the like of the substrate WF. For example, in Fig. 10A and Fig. 10B, the bag members 2335 are divided into groups 2335-1, 2335-2, and 2335-3, and a group 2335-4 that are concentrically arranged. The group 2335-1 includes nine bag members 2335 at the center. The group 2335-2 includes 40 bag members 2335 around the group 2335-1. The group 2335-3 includes 32 bag members 2335 around the group 2335-2. The group 2335-4 includes 40 bag members 2335 around the group 2335-3. The groups 2335-1, 2335-2, and 2335-3, and the group 2335-4 into which the bag members 2335 are grouped will be referred to as a "plurality of first groups A."

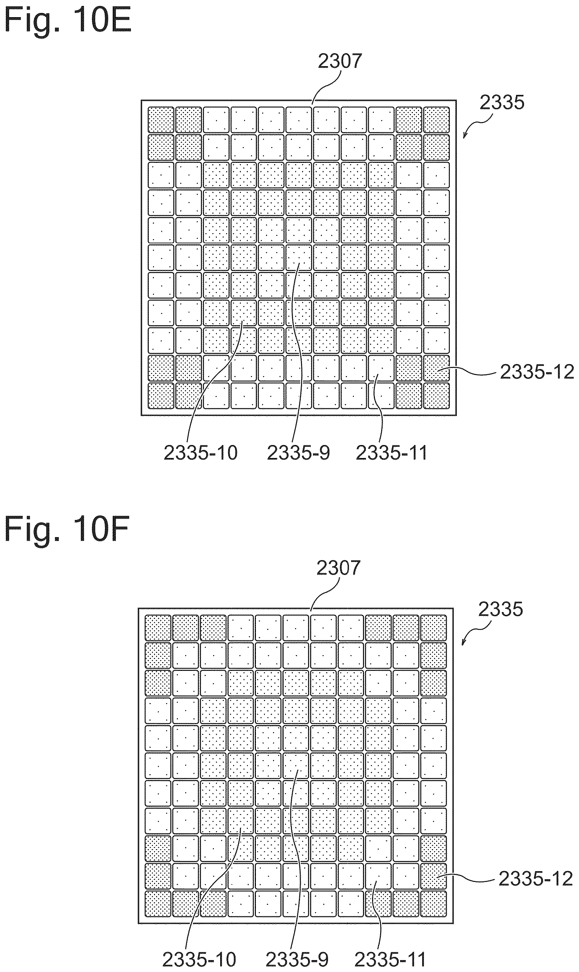

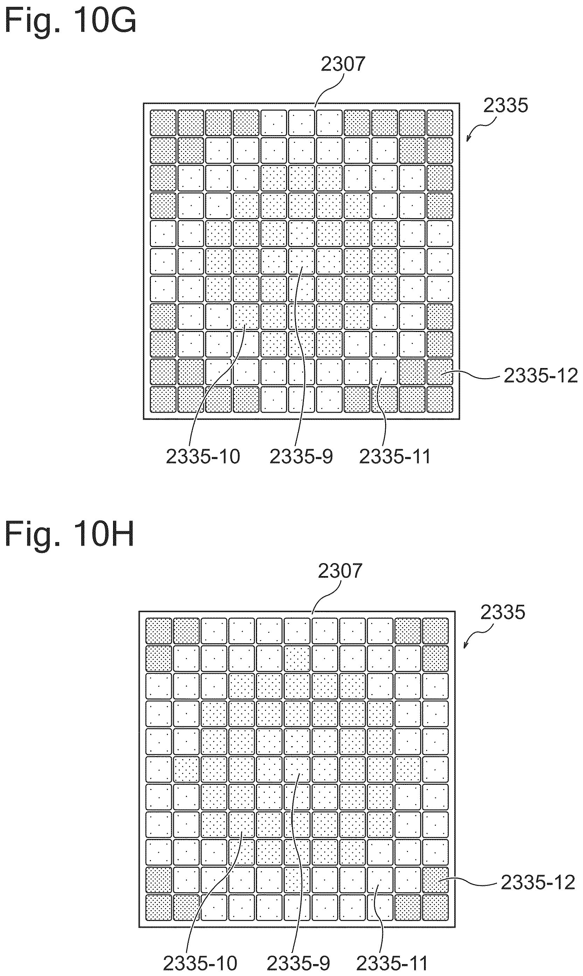

In the example illustrated in Fig. 10D, the bag members 2335 are divided into groups 2335-5, 2335-6, and 2335-7, and a group 2335-8 that are concentrically arranged. The group 2335-5 includes one bag member 2335 at the center. The group 2335-6 includes 8 bag members 2335 around the group 2335-5. The group 2335-7 includes 72 bag members 2335 around the group 2335-6. The group 2335-8 includes 40 bag members 2335 around the group 2335-7. The groups 2335-5, 2335-6, and 2335-7, and the group 2335-8 into which the bag members 2335 are grouped will be referred to as a "plurality of second groups B." In this embodiment, the example in which the bag members 2335 are grouped into the concentric groups is described. However, the grouping is not limited to this, and any manner of grouping (the number, shapes, etc. of groups) may be applied to the bag members 2335. Fig. 10E, Fig. 10F, Fig. 10G, and Fig. 10H are plan views schematically illustrating modifications of the grouping of the bag members 2335. Fig. 10E to Fig. 10H illustrate the state where the bag members 2335 are divided into groups 2335-9, 2335-10, 2335-11, and 2335-12. The grouping of the bag members 2335 is not limited to the "plurality of first groups A" and the "plurality of second groups B" described above. The bag members 2335 can be grouped as illustrated in Fig. 10E to Fig. 10H. That is, as illustrated in Fig. 10E to Fig. 10H, the bag members 2335 can be grouped such that pressing forces can be controlled for regions corresponding to the four corner portions of the substrate WF, each of which is regarded as one group (one of the groups 2335-12). As illustrated in Fig. 10F to Fig. 10H, bag members 2335 outside the group 2335-9 at the center and inside the groups 2335-12 corresponding to the four corner portions of the substrate WF may be grouped into groups each having a substantially annular shape, such as groups 2335-10 and 11. In this embodiment, the example in which the bag members 2335 each have a substantially quadrangular shape in plan view is described. However, not limited to this, the bag members 2335 may each have another shape such as a hexagon.

The channel of the distribution mechanism 2305 is configured to be switchable between a first channel 2306A for distributing the gas to the plurality of first groups A and a second channel 2306B for distributing the gas to the plurality of second groups B.

Specifically, the distribution mechanism 2305 is configured to be capable of making an exchange between a first distribution member 2306-1 having the first channel 2306A and a second distribution member 2306-2 having the second channel 2306B, as the distribution member 2306. Fig. 10A illustrates the state where the first distribution member 2306-1 is used as the distribution member 2306. As illustrated in Fig. 10A, the first channel 2306A includes a channel 2306-1a communicating with the bag members 2335 in the group 2335-1, a channel 2306-1b communicating the bag members 2335 in the group 2335-2, a channel 2306-1c communicating with the bag members 2335 in the group 2335-3, and a channel 2306-1d communicating with the bag members 2335 in the group 2335-4. By adjusting pressures of the fluid to be supplied to the channels 2306-1a, 2306-1b, 2306-1c, and 2306-1d, the pressing forces of the substrate WF can be controlled for the groups 2335-1, 2335-2, 2335-3, and 2335-4.

Fig. 10D illustrates the state where the second distribution member 2306-2 is used as the distribution member 2306. As illustrated in Fig. 10D, the second channel 2306B includes a channel 2306-2a communicating with the bag members 2335 in the group 2335-5, a channel 2306-2b communicating the bag members 2335 in the group 2335-6, a channel 2306-2c communicating with the bag members 2335 in the group 2335-7, and a channel 2306-2d communicating with the bag members 2335 in the group 2335-8. By adjusting pressures of the fluid to be supplied to the channels 2306-2a, 2306-2b, 2306-2c, and 2306-2d, the pressing forces of the substrate WF can be controlled for the groups 2335-5, 2335-6, 2335-7, and 2335-8.

As illustrated in Fig. 10A and Fig. 10D, by making an exchange between the first distribution member 2306-1 and the second distribution member 2306-2, it is possible to flexibly adjust pressurization areas of the substrate WF without replacing a plurality of bag members 2335.

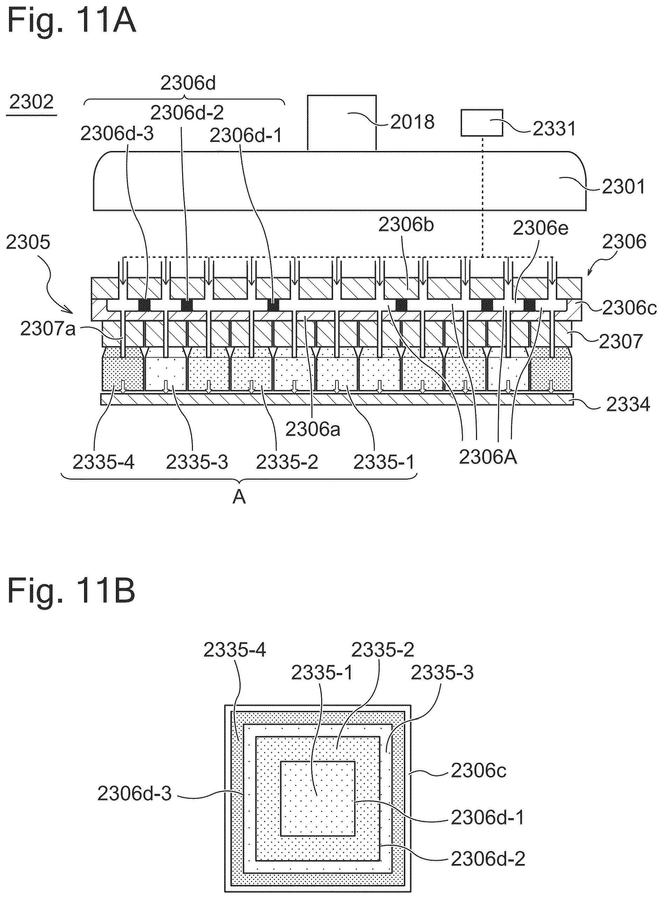

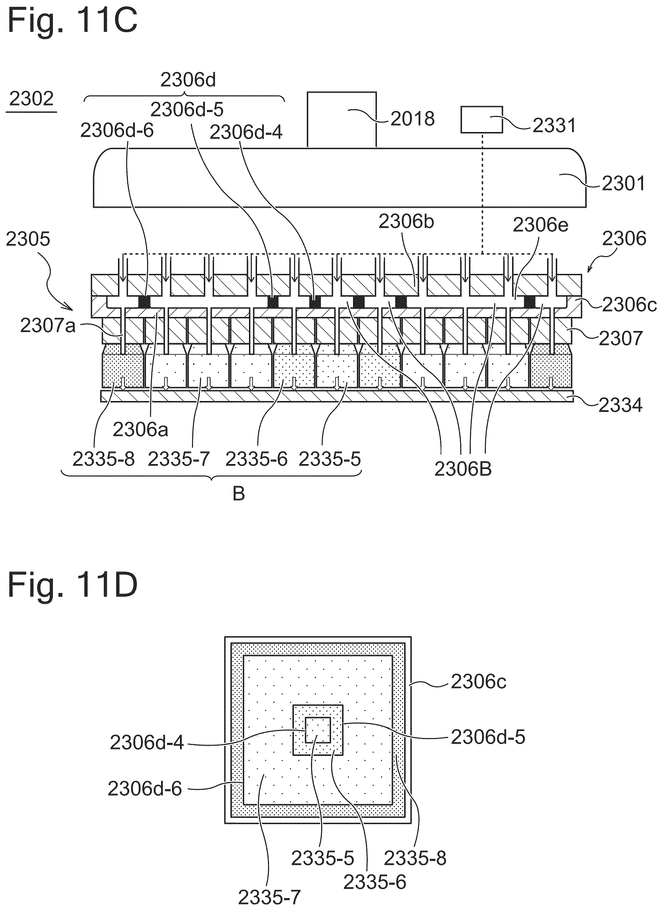

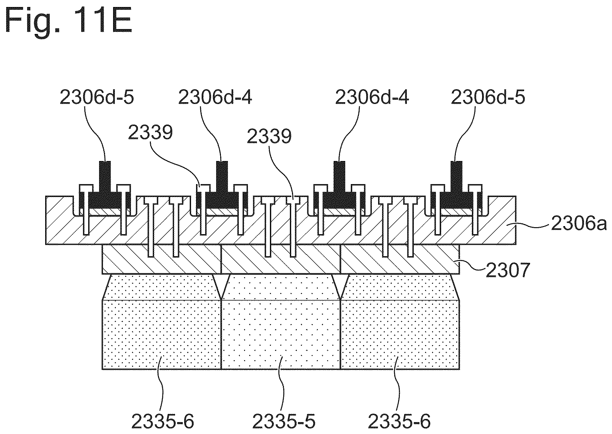

In the above embodiment, the exchange between the first distribution member 2306-1 and the second distribution member 2306-2 is described as an example. However, how to enable the flexible adjustment of the pressurization areas of the substrate WF is not limited to this. Fig. 11A is a cross-sectional view schematically illustrating a top ring of one embodiment. Fig. 11B is a plan view schematically illustrating the top ring in Fig. 11A. Fig. 11C is a cross-sectional view schematically illustrating the top ring of the one embodiment. Fig. 11D is a plan view schematically illustrating the top ring in Fig. 11C. Fig. 11E is a cross-sectional view schematically illustrating a partially enlarged top ring in Fig. 11C.

As illustrated in Fig. 11A, the distribution member 2306 includes a bottom wall 2306a coupled to the bag member holder 2307, a top wall 2306b disposed opposed to the bottom wall 2306a with a gap interposed therebetween, and a side wall 2306c connecting the peripheral edge portions of the bottom wall 2306a and the top wall 2306b. The distribution member 2306 also includes partition walls 2306d that have a quadrilateral-frame shape and partition a space 2306e surrounded by the bottom wall 2306a, the top wall 2306b, and the side wall 2306c. The distribution mechanism 2305 is configured to be capable of making an exchange between first partition walls 2306d-1, 2306d-2, and 2306d-3 for forming the first channel 2306A and second partition walls 2306d-4, 2306d-5, and 2306d-6 for forming the second channel 2306B, as the partition walls 2306d.

Fig. 11A and Fig. 11B illustrate the state where the first partition walls 2306d-1, 2306d-2, and 2306d-3 are used as the partition walls 2306d. By attaching the first partition walls 2306d-1, 2306d-2, and 2306d-3 to the bottom wall 2306a, the same first channel 2306A as in Fig. 10A is formed, and thus the gas can be distributed to the bag members 2335 in the plurality of first groups A.

Fig. 11C and Fig. 11D illustrate the state where the second partition walls 2306d-4, 2306d-5, and 2306d-6 are used as the partition walls 2306d. By attaching the second partition walls 2306d-4, 2306d-5, and 2306d-6 to the bottom wall 2306a, the same second channel 2306B as in Fig. 10D is formed, and thus the gas can be distributed to the bag members 2335 in the plurality of second groups B.

According to this embodiment, making an exchange between the first partition walls 2306d-1, 2306d-2, and 2306d-3 and the second partition walls 2306d-4, 2306d-5, and 2306d-6 makes it possible to flexibly adjust the pressurization areas of the substrate WF without replacing a plurality of bag members 2335. Note that Fig. 11A and Fig. 11C illustrate the partition walls 2306d in a simplified manner for convenience of description. As illustrated in Fig. 11E, the partition walls 2306d (for example, second partition walls 2306d-4 and 2306d-5) are attached to the bottom wall 2306a with bolts 2339. The partition walls 2306d can thus be detached from the bottom wall 2306a by removing the bolts 2339. The distribution member 2306 and the bag member holder 2307 are also connected by bolts 2339. On an upper surface of the bottom wall 2306a illustrated in Fig. 11E, as many (quadrangular) closed-loop grooves as possible may be provided in advance, and the partition walls 2306d may be placed on only closed-loop grooves necessary to provide a plurality of desired pressurization areas with a sealant (gaskets) interposed therebetween. In the above-described embodiments, the first channel 2306A and the second channel 2306B are each assumed to be a combination of a quadrilateral and quadrilateral loops. However, the channels are not limited to this. For example, in the modifications illustrated in Fig. 10E to Fig. 10H, the distribution member 2306 or the partition walls 2306d are configured in such a manner as to form island-shaped channels that correspond to substantial annular channels and (four) corner portions and (four) side portions of the substrate WF and are spaced apart from one another. By making the island-shaped channels corresponding to the corner portions or the side portions of the substrate WF communicate with one another at the upstream side of the distribution member 2306, the same pressure can be supplied for the corner portions or the side portions.

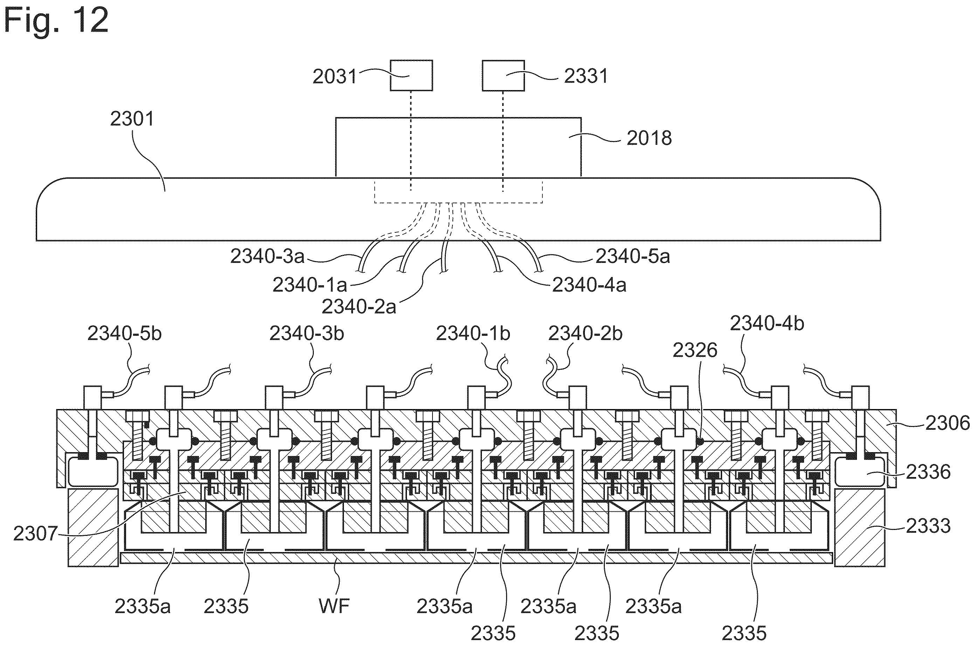

In the embodiments described above, the example in which the suction plate 2334 is provided below the bag members 2335 and used to hold the substrate WF by suction is described. However, the suction plate 2334 need not be provided. Fig. 12 is a cross-sectional view schematically illustrating a top ring of one embodiment.

As illustrated in FIG. 12, the plurality of bag members 2335 are provided with holes 2335a in their bottom walls. In the example illustrated in Fig. 12, a retainer ring 2333 is provided around the plurality of bag members 2335 to prevent the substrate WF from being disengaged from the top ring. The retainer ring 2333 can be pressurized by an air bag 2336 provided above the retainer ring 2333. Note that the holes 2335a need not be provided in the bottom walls of all the bag members 2335. Some of the bag members 2335 may be provided with holes 2335a in their bottom walls. Since all the bag members 2335 have the same shape and the same size, installation positions of the bag members 2335 with the holes 2335a can be easily changed to desired positions.

As illustrated in Fig. 12, a plurality of tubes 2340-1a to 2340-5a are provided through the rotation shaft 2018 and the carrier 2301 between which a rotary joint is built. These tubes 2340-1a to 2340-5a are connected to the gas supply source 2331 and pressure reducing means 2031.

The distribution member 2306 is provided with a plurality of tubes 2340-1b to 2340-4b communicating with the channel for distributing the gas to the bag members 2335 and a tube 2340-5b for supplying the gas to the air bag 2336. Around the channels of the distribution member 2306, O-rings 2326 are disposed, making seals between the channels. By connecting the plurality of tubes 2340-1a to 2340-4a to the plurality of tubes 2340-1b to 2340-4b, the gas can be sucked from the plurality of bag members 2335 and can be supplied to the plurality of bag members 2335. As a result, when holding the substrate WF, the top ring can suction the substrate WF by sucking the gas through the holes 2335a of the bag members. When the polishing is performed, it is possible to flexibly adjust the pressurization areas of the substrate WF by adjusting the gas to be supplied to the plurality of bag members 2335. By connecting the tube 2340-5a and the tube 2340-5b, the retainer ring 2333 can be pressed with the air bag 2336.

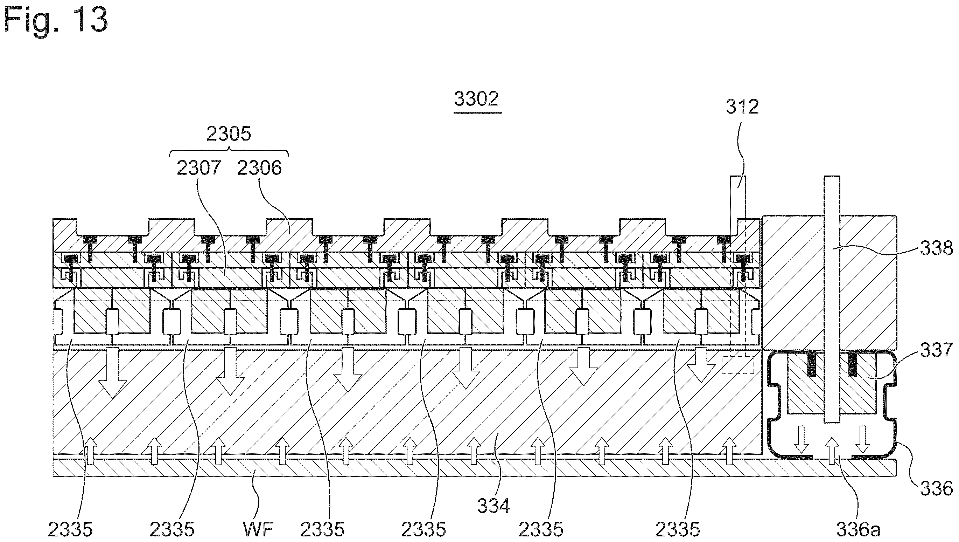

Fig. 13 is a cross-sectional view schematically illustrating a partially enlarged top ring of one embodiment. In the following description, the same components as those in the above-described embodiments will be denoted by the same reference characters. As illustrated in Fig. 13, the bag member 336, and the plurality of bag members 2335 and the distribution mechanism 2305 in the above embodiments may be combined. That is, as illustrated in Fig. 13, a top ring 3302 may include the distribution mechanism 2305, the plurality of bag members 2335, the porous member 334 disposed below the plurality of bag members 2335, and the bag member 336 disposed so as to surround the porous member 334. According to this embodiment, it is possible to flexibly adjust the pressurization areas of the substrate WF and to prevent the peripheral edge portion of the substrate WF from being broken when the substrate WF is suctioned. Note that Fig. 13 and its subsequent drawings illustrate examples in which the bag members 2335 each have a hexagonal shape in plan view and are provided with depressions on their side walls for preventing the bag members 2335 from deforming.

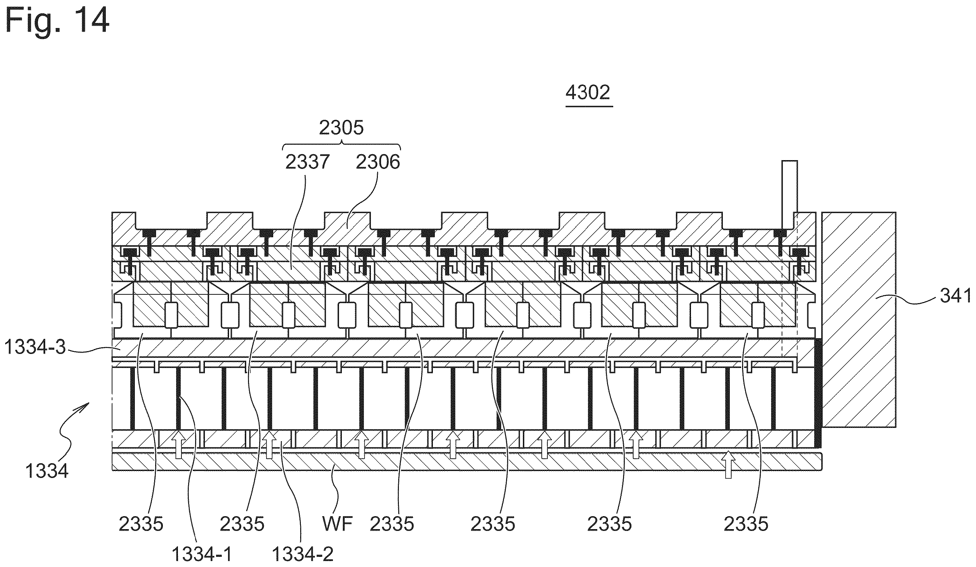

Fig. 14 is a cross-sectional view schematically illustrating a partially enlarged top ring of one embodiment. As illustrated in Fig. 14, the plurality of bag members 2335 and the distribution mechanism 2305, and the honeycomb-structure suction member 1334 in the above embodiments may be combined. That is, as illustrated in Fig. 14, a top ring 4302 may include the distribution mechanism 2305, the plurality of bag members 2335, and the honeycomb-structure suction member 1334 disposed below the plurality of bag members 2335. The top ring 4302 may also include the restricting member 341 disposed around outermost bag members 2335 and being for restricting the outward expansion of the bag members 2335. According to this embodiment, it is possible to achieve an increase in the strength of the top ring 4302 and a decrease in the weight of the top ring 4302 and to flexibly adjust the pressurization areas of the substrate WF.

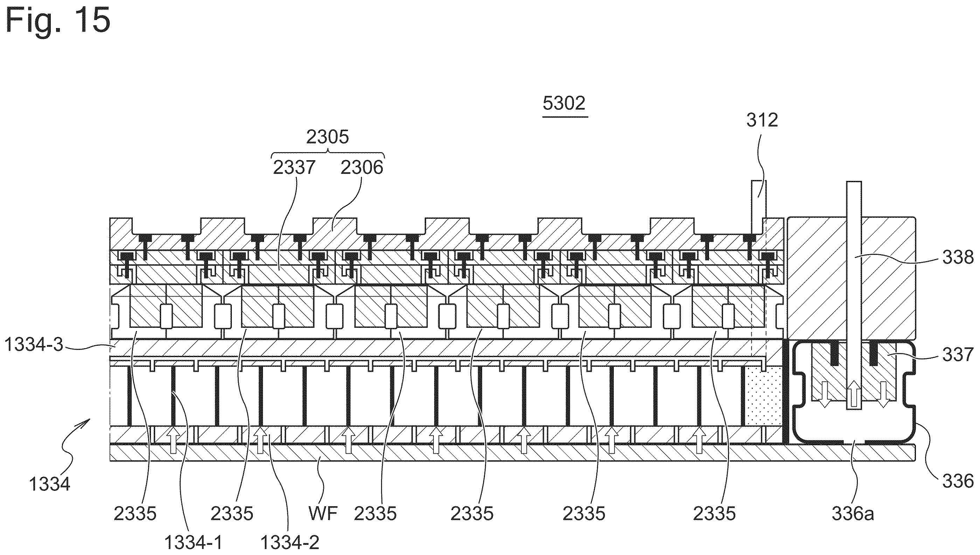

Fig. 15 is a cross-sectional view schematically illustrating a partially enlarged top ring of one embodiment. As illustrated in Fig. 15, the plurality of bag members 2335 and the distribution mechanism 2305, the honeycomb-structure suction member 1334, and the bag member 336 in the above embodiments may be combined. That is, as illustrated in Fig. 15, a top ring 5302 may include the distribution mechanism 2305, the plurality of bag members 2335, the honeycomb-structure suction member 1334 disposed below the plurality of bag members 2335, and the bag member 336 disposed so as to surround the honeycomb-structure suction member 1334. According to this embodiment, it is possible to achieve an increase in a strength of the top ring 5302 and a decrease in a weight of the top ring 5302, to flexibly adjust the pressurization areas of the substrate WF, and to prevent the peripheral edge portion of the substrate WF from being broken when the substrate WF is suctioned.

While several embodiments of the present invention have been described above, the above-described embodiments of the present invention are intended to facilitate understanding of the present invention and are not intended to limit the present invention. The present invention can be changed or improved without departing from the gist thereof, and obviously, the equivalents of the present invention are included in the present invention. To the extent that at least part of the above-described problems can be solved, or at least part of the effect can be achieved, any combination or omission of each component described in the claims and specification is possible.

The present application discloses, as one embodiment, a substrate suction member including a porous member that includes a substrate suction surface for suctioning a substrate and pressure reducers communicating with pressure reducing means, a shielding member shielding a surface of the porous member opposite to the substrate suction surface, and a bag member disposed so as to surround the porous member and communicating with a gas supply source.

The present application further discloses, as one embodiment, the substrate suction member in which the bag member includes an inner-circumference side wall in contact with the porous member and a bottom wall in contact with the substrate.

The present application further discloses, as one embodiment, the substrate suction member in which the bottom wall has a plurality of holes disposed so as to surround the porous member or a slit formed so as to surround the porous member.

The present application further discloses, as one embodiment, the substrate suction member in which the bag member further includes an outer-circumference side wall opposed to the inner-circumference side wall, and in an internal space of the bag member, a reinforcing member having a higher stiffness than the bag member is attached to at least one of the inner-circumference side wall or the outer-circumference side wall.

The present application further discloses, as one embodiment, the substrate suction member that further includes a restricting member disposed so as to surround the outer-circumference side wall of the bag member and configured to restrict the outward expansion of the bag member.

The present application further discloses, as one embodiment, the top ring for holding a substrate, and the top ring includes a rotation shaft, a carrier coupled to the rotation shaft, and the above-described substrate suction member attached to the carrier.

The present application further discloses, as one embodiment, the top ring in which a pressurization space for pressurizing the substrate is formed between the carrier and the shielding member, and in the pressurization space, a plurality of elastic films being configured to form a plurality of pressurization chambers for pressurizing a plurality of respective regions of the substrate are provided.

The present application further discloses, as one embodiment, the substrate processing apparatus including a polishing table to which a polishing pad having a polishing surface is attached, the above-described top ring configured to hold and press a substrate against the polishing surface, and a polishing liquid supply nozzle configured to supply a polishing liquid to the polishing pad.

The present application discloses, as one embodiment, the top ring for holding and pressing a substrate against a polishing surface, the top ring includes a plurality of bag members configured to press the substrate using a gas supplied from a gas supply source and a distribution mechanism including a channel for distributing the gas supplied from the gas supply source to the plurality of bag members. The distribution mechanism is configured such that the channel is switchable between a first channel for distributing the gas to a plurality of first groups into which the plurality of bag members are configured to be grouped and a second channel for distributing the gas to a plurality of second groups that are different from the plurality of first groups and into which the plurality of bag members are configured to be grouped.

The present application further discloses, as one embodiment, the top ring in which the distribution mechanism includes a bag member holder configured to hold the plurality of bag members and provided with communication passages communicating with the internal spaces of the plurality of bag members and includes a distribution member for distributing the gas supplied from the gas supply source to the communication passages of the bag member holder.

The present application further discloses, as one embodiment, the top ring in which the distribution mechanism is configured to be capable of making an exchange between a first distribution member having the first channel and a second distribution member having the second channel, as the distribution member.

The present application further discloses, as one embodiment, the top ring in which the distribution member includes a bottom wall coupled to the bag member holder, a top wall disposed opposed to the bottom wall with a gap interposed between the bottom wall and the top wall, a side wall connecting the peripheral edge portions of the bottom wall and the top wall, and partition walls partitioning a space surrounded by the bottom wall, the top wall, and the side wall. The distribution mechanism is configured to be capable of making an exchange between the first partition walls configured to form the first channel and the second partition walls configured to form the second channel, as the partition walls.

The present application further discloses, as one embodiment, the top ring in which the plurality of bag members are two-dimensionally arranged opposed to a pressed surface of the substrate, the plurality of first groups are concentrically arranged, and the plurality of second groups are concentrically arranged.

The present application further discloses, as one embodiment, the top ring further including a suction plate disposed on a substrate-pressing-surface side of the plurality of bag members, and the plurality of bag members are configured to press the substrate via the suction plate.

The present application further discloses, as one embodiment, the top ring further including a rotation shaft and a carrier that is coupled to the rotation shaft. The distribution mechanism is disposed between the carrier and the plurality of bag members.

The present application further discloses, as one embodiment, the substrate processing apparatus including a polishing table to which a polishing pad having a polishing surface is attached, the top ring according to any one of the above disclosures that is configured to hold and press a substrate against the polishing surface, a polishing liquid supply nozzle configured to supply a polishing liquid to the polishing pad, and a gas supply source configured to supply a gas to plurality of bag members of the top ring.

### REFERENCE SIGNS LIST

- 18, 2018: top ring shaft (rotation shaft)
- 31, 2031: pressure reducing means (vacuum source)
- 300: polishing unit
- 301, 2301: carrier
- 302, 1302, 2302, 3302, 4302, 5302: top ring
- 312: gas channel
- 320: elastic film
- 322: pressurization space
- 330: substrate suction member
- 331, 2331: gas supply source
- 332: shielding member
- 334: porous member
- 334a: substrate suction surface
- 334b: pressure reducer
- 335: reinforcing member
- 336: bag member (air bag)
- 336-1: inner-circumference side wall
- 336-2: bottom wall
- 336-3: outer-circumference side wall
- 336a: hole
- 336b: slit
- 338: gas channel
- 341: restricting member
- 350: polishing table
- 352: polishing pad
- 352a: surface (polishing surface)
- 354: polishing liquid supply nozzle
- 1000: substrate processing apparatus
- 2305: distribution mechanism
- 2306: distribution member
- 2306-1: first distribution member
- 2306-2: second distribution member
- 2306A: first channel
- 2306B: second channel
- 2306a: bottom wall
- 2306b: top wall
- 2306c: side wall
- 2306d: partition wall
- 2306d-1, 2306d-2, 2306d-3: first partition wall
- 2306d-4, 2306d-5, 2306d-6: second partition wall
- 2307: bag member holder
- 2307a: communication passage
- 2334: suction plate
- 2335: bag member (air bag)
- A: plurality of first groups
- B: plurality of second groups
- WF: substrate

## Claims

1. A substrate suction member comprising:
a porous member including a substrate suction surface and pressure reducers, the substrate suction surface being for suctioning a substrate, the pressure reducers communicating with pressure reducing means;
a shielding member shielding a surface of the porous member opposite to the substrate suction surface; and
a bag member disposed so as to surround the porous member and communicating with a gas supply source.

2. The substrate suction member according to claim 1, wherein
the bag member includes an inner-circumference side wall and a bottom wall, the inner-circumference side wall being in contact with the porous member, the bottom wall being in contact with the substrate.

3. The substrate suction member according to claim 2, wherein
the bottom wall includes a plurality of holes or a slit, the plurality of holes being disposed so as to surround the porous member, the slit being formed so as to surround the porous member.

4. The substrate suction member according to claim 3, wherein
the bag member further includes an outer-circumference side wall opposed to the inner-circumference side wall, and
in an internal space of the bag member, a reinforcing member is attached to at least one of the inner-circumference side wall or the outer-circumference side wall, the reinforcing member having a higher stiffness than the bag member.

5. The substrate suction member according to claim 4, further comprising
a restricting member disposed so as to surround the outer-circumference side wall of the bag member and configured to restrict outward expansion of the bag member.

6. A top ring for holding a substrate, comprising:
a rotation shaft;
a carrier coupled to the rotation shaft; and
the substrate suction member according to any one of claims 1 to 5, the substrate suction member being attached to the carrier.

7. The top ring according to claim 6, wherein
a pressurization space is formed between the carrier and the shielding member, the pressurization space being for pressurizing the substrate, and
in the pressurization space, a plurality of elastic films are provided, the plurality of elastic films being configured to form a plurality of pressurization chambers for pressurizing a plurality of respective regions of the substrate.

8. A substrate processing apparatus comprising:
a polishing table to which a polishing pad is attached, the polishing pad having a polishing surface;
the top ring according to claim 6, the top ring being configured to hold and press the substrate against the polishing surface; and
a polishing liquid supply nozzle configured to supply a polishing liquid to the polishing pad.

9. A top ring for holding and pressing a substrate against a polishing surface, the top ring comprising:
a plurality of bag members configured to press the substrate using a gas supplied from a gas supply source; and
a distribution mechanism including a channel for distributing the gas supplied from the gas supply source to the plurality of bag members, the distribution mechanism being configured such that the channel is switchable between a first channel and a second channel, the first channel being for distributing the gas to a plurality of first groups into which the plurality of bag members are configured to be grouped, the second channel being for distributing the gas to a plurality of second groups into which the plurality of bag members are configured to be grouped, the plurality of second groups being different from the plurality of first groups.

10. The top ring according to claim 9, wherein
the distribution mechanism includes:
a bag member holder configured to hold the plurality of bag members and provided with communication passages communicating with internal spaces of the plurality of bag members; and
a distribution member for distributing the gas supplied from the gas supply source to the communication passages of the bag member holder.

11. The top ring according to claim 10, wherein
the distribution mechanism is configured to be capable of making an exchange between a first distribution member and a second distribution member as the distribution member, the first distribution member including the first channel, the second distribution member including the second channel.

12. The top ring according to claim 10, wherein
the distribution member includes a bottom wall, a top wall, a side wall, and partition walls, the bottom wall being coupled to the bag member holder, the top wall being disposed opposed to the bottom wall with a gap interposed between the bottom wall and the top wall, the side wall connecting peripheral edge portions of the bottom wall and the top wall, the partition walls partitioning a space surrounded by the bottom wall, the top wall, and the side wall, and
the distribution mechanism is configured to be capable of making an exchange between first partition walls and second partition walls as the partition walls, the first partition walls being configured to form the first channel, the second partition walls configured to form the second channel.

13. The top ring according to any one of claims 9 to 12, wherein
the plurality of bag members are two-dimensionally arranged opposed to a pressed surface of the substrate, the plurality of first groups are concentrically arranged, and the plurality of second groups are concentrically arranged.

14. The top ring according to claim 13, further comprising
a suction plate disposed on a substrate-pressing-surface side of the plurality of bag members, wherein
the plurality of bag members are configured to press the substrate via the suction plate.

15. The top ring according to claim 14, further comprising:
a rotation shaft; and
a carrier coupled to the rotation shaft, wherein
the distribution mechanism is disposed between the carrier and the plurality of bag members.

16. A substrate processing apparatus comprising:
a polishing table to which a polishing pad is attached, the polishing pad having a polishing surface;
the top ring according to claim 9, the top ring being configured to hold and press the substrate against the polishing surface;
a polishing liquid supply nozzle configured to supply a polishing liquid to the polishing pad; and
a gas supply source configured to supply a gas to the plurality of bag members of the top ring.
